# FASCICULE DE BREVET EUROPEEN

(11) **EP 2 075 105 B1**
(45) Date de publication et mention de la délivrance du brevet: **23.06.2010**
(21) Numéro de dépôt: 08291231.2
(22) Date de dépôt: 23.12.2008
(51) Int. Cl.: B28D 5/00, B28D 5/04

(54) **Procédé et dispositif de séparation d'une structure**
Verfahren und Vorrichtung zur Trennung einer Struktur
Method and device for separating a structure

(30) Priorité: 28.12.2007 FR 0760437
(43) Date de publication de la demande: 01.07.2009
(73) Titulaire: Commissariat à l'Energie Atomique, 75015 Paris (FR)
(72) Inventeur: Zussy, Marc, 38120 Saint-Egrève (FR); Di Cioccio, Léa, 38330 Saint Ismier (FR); Morales, Christophe, 38800 Le Pont de Claix (FR); Moriceau, Hubert, 38120 Saint-Egrève (FR)
(74) Mandataire: Quantin, Bruno Marie Henri

(56) Documents cités:
- EP-B- 1 385 683
- DE-A1- 3 102 766

## Description

L'invention concerne un procédé de séparation d'une structure, utile par exemple dans les domaines de la micro-électronique, de l'optique ou de l'optoélectronique. L'invention concerne également un dispositif de séparation associé.

L'invention vise notamment à séparer une structure en deux parties parallèles (ou sous-structures). De manière générale, dans le domaine de la micro-électronique, on souhaite souvent séparer, dans son épaisseur, une structure de matériaux empilés, soit au niveau d'une interface de collage entre deux plaques de matériaux collées l'une sur l'autre, soit suivant un plan de faiblesse, soit suivant un plan de contraintes existant dans la structure empilée ou encore au niveau d'une interface de dépôt.

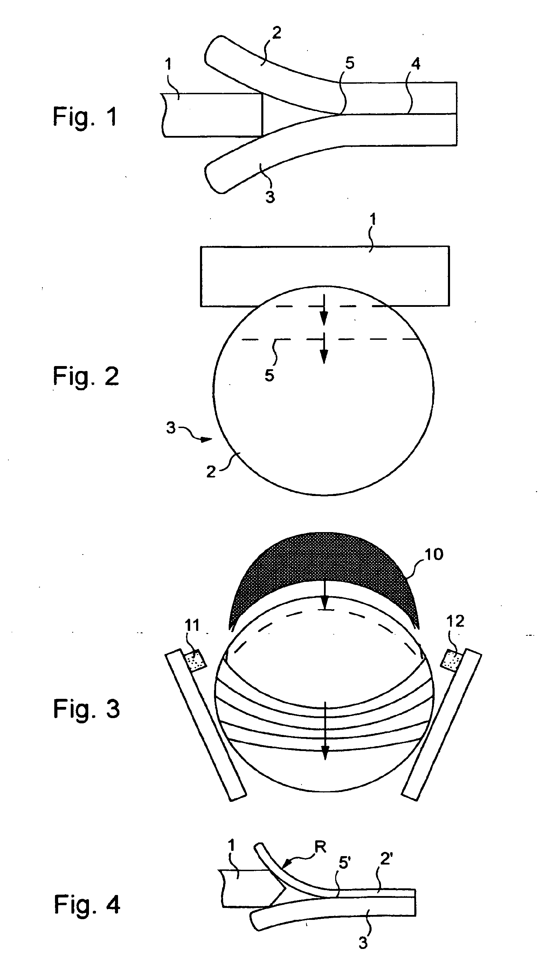

Une technique connue pour la séparation de plaques collées, représentée en figures 1 et 2, implique l'insertion d'une lame 1 par poussée depuis l'extérieur des plaques collées 2 et 3 au niveau de l'interface de collage 4 vers l'intérieur de celui-ci dans son plan, selon une direction radiale. Il s'en suit une ouverture progressive de la structure collée, un front de décollement 5 s'établissant en avant de la lame, qui a ainsi un rôle de coin.

Les lames utilisées ont typiquement une épaisseur de l'ordre d'un millimètre, avec éventuellement un bord d'attaque possédant un rayon de courbure de l'ordre d'une dizaine de microns d'épaisseur (ou alternativement un bord d'attaque anguleux comme en figure 1). La zone de décollement induite par l'introduction de la lame est d'autant plus grande, et le front de décollement est d'autant plus en avance sur la lame, que celle-ci est épaisse, du fait de l'effet de coin.

On peut noter que la surface de la zone de décollement induite par l'introduction de la lame est d'autant plus petite que l'énergie de collage entre les plaques est forte. L'insertion d'une lame comme représentée en figures 1 et 2 a de ce fait été utilisée pour déterminer l'énergie de collage entre des plaques.

On connaît également une méthode de séparation de plaques impliquant une insertion simultanée de plusieurs lames à différents endroits de la périphérie de l'interface des plaques, chaque lame étant dirigée vers le centre de la structure empilée (voir « Debonding of Wafer-Bonded Interfaces for Handling and Transfer Applications », de J. Bagdahn et M. Petzold, dans Wafer Bonding Applications and Technology, ed. Springer.

La séparation de la structure collée est ainsi initiée à partir de plusieurs zones périphériques, la zone centrale se décollant par exemple quand les fronts de décollement induits par les lames convergent en elle.

Une autre méthode connue pour la séparation de plaques collées, décrite dans le document EP 1 385 683 B1, utilise une lame dont le bord d'attaque est de forme concave avec une courbure correspondant à celle de la périphérie des plaques à séparer.

Le mouvement de la lame est une translation radiale de la périphérie vers le centre de la structure à séparer, le long de l'interface de collage, provoquant la séparation des plaques simultanément sur une large partie de la circonférence de l'interface.

Selon une variante de cette dernière méthode, représentée en figure 3, on utilise, en plus d'une lame concave 10, des lames latérales 11 et 12 appliquées à la structure, à distance de la zone à laquelle est appliquée la lame concave 10, de part et d'autre de celle-ci, toujours dans le plan de l'interface de collage.

Chaque lame latérale 11 avance selon une trajectoire rectiligne le long du flanc des plaques, dans le plan de l'interface, au contact des plaques, en s'éloignant de la zone ouverte par la lame concave 10, contribuant ainsi à la séparation des deux plaques.

Ces techniques présentent différents inconvénients.

Tout d'abord, l'insertion d'une lame et sa progression entraînent une déformation des couches de matériau proches de la zone de séparation. Cette déformation est notamment critique quand, comme représenté en figure 4, une des sous-structures, notée sous-structure fine 2', est de faible épaisseur par rapport à l'épaisseur de la lame 1, auquel cas le front de décollement est proche de la lame 1, et la courbure R subie par la sous-structure fine 2' est telle qu'une cassure de celle-ci peut intervenir.

Par ailleurs, la lame utilisée ne doit pas être trop fine, compte tenu des efforts qu'elle est amenée à subir, parmi lesquels on peut citer les efforts de compression du fait de la poussée, et des frottements contre les plaques au niveau des surfaces décollées. Il en résulte qu'une lame trop fine manipulée selon les procédés de séparation connus mène en pratique à des résultats de séparation non reproductibles.

A cela s'ajoute une possible détérioration des surfaces séparées causées par l'introduction d'impuretés sur la zone de déplacement de la lame.

Enfin, dans certains cas, se présentent des phénomènes de recollement des deux sous-structures séparées, après le passage de la lame.

L'invention a pour objet de pallier aux inconvénients précités, en proposant un procédé et un dispositif de séparation qui soit bien contrôlable même pour la séparation de structures comportant au moins une sous-structure à séparer de faible épaisseur (par exemple de moins de 50 microns d'épaisseur) sur une surface importante.

L'invention propose à cet effet, un procédé de séparation d'une structure comprenant une zone fragile délimitant dans cette structure deux sous-structures à séparer, selon lequel on fait avancer au moins une lame plane suivant une direction d'avance dans un plan de séparation correspondant à un plan moyen de la zone fragile, depuis un bord d'entrée de la structure en direction d'un bord de sortie de la structure, en sorte de provoquer une séparation progressive des deux sous-structures, le procédé étant caractérisé en ce qu'on fait varier l'inclinaison de la lame dans le plan de séparation vis-à vis de la direction d'avance.

Ce procédé permet de faire varier la répartition des efforts exercés par la lame sur la structure. Cela permet de mieux contrôler le processus de séparation. Le processus de séparation étant mieux contrôlé, on peut utiliser une lame plus fine. Il en découle une diminution des risques de détérioration des surfaces mises à nu par la séparation et des risques de rupture des sous-structures. Finalement, le procédé permet d'effectuer une séparation de meilleure qualité, y compris quand une des sous-structures est fine.

Selon une caractéristique optionnelle, on fait avancer la lame par des efforts appliqués à des portions latérales de la lame, avantageusement en traction.

On précise que cette caractéristique, originale en soi, peut être mise en oeuvre quelque soit le mouvement de la lame, mais elle est particulièrement intéressante dans le cadre de l'application d'un mouvement au cours duquel l'inclinaison de la lame dans le plan de séparation est modifiée au cours de sa progression.

Grâce à cette caractéristique, la lame peut ne pas être sollicitée en poussée pendant sa progression entre les deux sous-structures.

Il en découle qu'il n'est pas nécessaire que la lame présente une grande rigidité, ce qui permet de lui donner une épaisseur moindre.

Le procédé peut donc être utilisé pour séparer des structures comportant au moins une sous-structure de faible épaisseur.

Selon une caractéristique optionnelle, on fait varier l'inclinaison de la lame en la faisant tourner autour d'un centre instantané de rotation situé dans le plan de séparation (ce point pouvant être fixe ou mobile par rapport à la lame).

Selon une caractéristique optionnelle, le mouvement de la lame peut comporter une composante en translation dans le plan de séparation perpendiculairement à la direction d'avance.

Selon une caractéristique optionnelle, un front de séparation délimitant au sein de la zone de maintien une zone ouverte où les deux sous-structures sont localement séparées et une zone fermée où les deux sous-structures sont encore liées, on fait varier l'inclinaison de la lame dans le plan de séparation en sorte de modifier une courbure dudit front de séparation.

Selon une caractéristique optionnelle, un front de séparation délimitant au sein de la zone de maintien une zone ouverte où les deux sous-structures sont localement séparées et une zone fermée où les deux sous-structures sont encore liées, on fait varier l'inclinaison de la lame dans le plan de séparation en sorte de modifier une longueur dudit front de séparation, par exemple en l'augmentant.

On précise qu'une longueur du front de séparation peut être prise entre deux bords latéraux de la zone de maintien.

Selon une caractéristique optionnelle, on fait varier l'inclinaison alternativement dans un sens et dans l'autre, au fur et à mesure de l'avance de la lame.

Selon une caractéristique optionnelle, la zone de maintien ou la zone fragile est une interface de collage constituée par un collage entre une surface d'une première des deux sous-structures et une surface de la deuxième des deux sous-structures.

Selon une caractéristique optionnelle, la zone de maintien ou la zone fragile est une zone interne de ladite structure mécaniquement affaiblie par une modification physique, chimique ou physico-chimique subie par un constituant de ladite zone interne.

Il peut s'agir d'une zone poreuse enterrée ou encore d'une zone fragile enterrée créée par implantation, par exemple d'espèce gazeuses, ou d'un film enterré de viscosité plus faible ou encore d'une interface de dépôt.

Selon une caractéristique optionnelle, une des deux sous-structures a une épaisseur inférieure à 50 µm, mesurée perpendiculairement audit plan d'application.

Selon une caractéristique optionnelle, une des deux sous-structures a une épaisseur inférieure à 15 µm mesurée perpendiculairement audit plan d'application.

Selon des caractéristiques optionnelles, le bord d'attaque de la lame est linéaire, courbe ou anguleux.

Selon une caractéristique optionnelle, le bord d'attaque peut discontinu. La lame peut par exemple être dentelée ou constituée de plusieurs éléments, animés d'un mouvement tel que décrit précédemment, le même ou non pour tous les éléments mais avec la même direction d'avance.

Selon une caractéristique optionnelle, la lame s'étend dans son plan, parallèlement à la direction d'avance, de telle sorte qu'elle reste interposée entre les deux sous-structures tout au long du procédé de séparation.

De cette manière, la lame empêche un recollement par contact des deux sous-structures, après le passage du bord d'attaque de la lame.

Selon une caractéristique optionnelle, une platine aspirante assure le maintien en position de la structure par application d'une aspiration sur une surface libre de cette structure.

Cela permet de maintenir ou d'immobiliser la sous-structure aspirée pendant l'opération de séparation, malgré les efforts appliqués par la lame.

Selon une caractéristique optionnelle, le mouvement d'inclinaison de ladite lame est asservi à un signal issu d'une caméra par exemple infra-rouge filmant la structure par exemple suivant une direction transversale au plan de séparation.

Une telle caméra infra-rouge peut permettre de visualiser le front de séparation. On précise que la vitesse de la variation de l'inclinaison de la lame dans son plan et la progression des extrémités de la lame peuvent être asservies, par exemple à un paramètre de progression du front de séparation.

Selon une caractéristique optionnelle, on fait varier l'inclinaison de la lame dans une plage d'au moins +/- 20° par rapport à une inclinaison de référence.

Dans la pratique, l'inclinaison varie en fonction de la structure et de ses matériaux constitutifs. Elle peut prendre toute valeur, par exemple 1° voire moins, 10°, 30° ou 90° voire plus.

Par ailleurs, pour la variation d'inclinaison, on peut choisir une vitesse de variation d'inclinaison d'autant plus faible que la structure est constituée de matériaux fragiles. Egalement on peut choisir une vitesse de variation d'inclinaison d'autant plus faible que l'énergie de maintien des deux structures entre elles est élevée.

Selon une caractéristique optionnelle, la structure comprend un matériau semi-conducteur.

Le matériau semi-conducteur peut être par exemple : le germanium, le silicium, un alliage silicium-germanium SiₓGe_{y}, un semi-conducteur composé III-V, notamment GaAs, GaN ou InP ou un semi-conducteur composé II-VI tel ZnS, ZnSe ou CdTe, ou aussi du SiC.

Selon une caractéristique optionnelle, la structure comprend un matériau isolant.

Les matériaux isolants utilisés peuvent être le verre, le saphir, le tantalate ou le niobate de lithium LiTaO₃ et LiNbO₃, le diamant, les grenats, l'alumine ou des polymères. On préfère notamment une structure verre/verre.

Selon une caractéristique optionnelle, la structure comprend un matériau conducteur.

Un matériau conducteur peut être choisi par exemple parmi les siliciures, les germaniures ou l'oxyde d'indium-étain ITO.

Le matériau choisi peut également être un métal, par exemple, Cu, Ni, W, Pd ou Pt.

Selon une caractéristique optionnelle, les deux sous-structures contiennent des matériaux différents.

Avantageusement, on utilise par exemple une structure hétérogène, notamment une structure Si/verre, mais aussi Si/saphir, SiₓGe_{y}/verre ou grenat/verre, la zone de maintien étant une zone de collage entre les deux matériaux.

Selon une caractéristique optionnelle, l'une des sous-structures présente, suivant une direction parallèle au plan de la zone de maintien ou au plan de séparation, depuis le bord vers l'intérieur de la structure, une zone d'épaisseur maximale puis une zone d'épaisseur minimale significativement plus faible que l'épaisseur de la zone d'épaisseur maximale, l'épaisseur étant mesurée perpendiculairement au plan de séparation.

La zone mince, distante des bords de la structure, peut résulter d'un amincissement préalable réalisé perpendiculairement au plan de la zone de maintien. La zone épaisse peut posséder l'épaisseur originelle de la sous-structure.

Cela permet de procéder à la séparation d'un fin film de matériau d'une structure à laquelle le film est initialement collé, le film étant rigidifié par la présence de la zone épaisse, qui peut constituer une armature périphérique autour du film. Ainsi, les risques de cassure du film, ou de déformation de celui-ci sont diminués.

Selon une caractéristique optionnelle la lame a une épaisseur au plus égale à 100 µm.

En effet, l'invention permet d'utiliser des lames de faible épaisseur, et donc de n'imposer que de faibles déformations aux couches à séparer au niveau du front de séparation. Les risques de cassure des structures séparées sont donc diminués.

En pratique, au moins un des paramètres choisis parmi l'épaisseur de la lame transversalement au plan de la lame, l'élasticité ou la dureté de la lame est choisie en fonction de la structure à séparer.

Par exemple, une épaisseur de 80 µm est adaptée pour séparer une membrane de 50 à 100 µm de verre d'un substrat de silicium de 725 µm d'épaisseur sur lequel cette membrane est collée.

On précise de plus que la lame peut être rigide ou flexible, et que dans ce cas, elle peut être présentée par exemple sous forme de rouleau déroulable.

Selon une caractéristique optionnelle, la lame comprend de l'aluminium.

Ce matériau offre une bonne résistance à la corrosion et de bonnes performances mécaniques. Selon une variante avantageuse, la lame, par exemple d'aluminium est couverte d'un film de Téflon™ facilitant l'introduction de la lame entre les structures collées et renforçant la prévention d'un recollage des structures une fois décollées.

Selon une caractéristique optionnelle, la lame comprend un film plastique ou un polymère thermoplastique.

Selon une caractéristique optionnelle, la lame comprend du Kapton®.

Selon une caractéristique optionnelle, la lame comprend du papier.

Selon une caractéristique optionnelle, la lame comprend un matériau composite comme de la fibre de carbone.

On comprend que, selon le matériau choisi pour la lame et l'épaisseur choisie, on obtient une lame que l'on peut qualifier de rigide, de flexible, ou de semi-rigide.

L'invention propose aussi un dispositif de séparation d'une structure comprenant une zone fragile délimitant deux sous-structures ou zone de maintien entre deux sous-structures de ladite structure, le dispositif comprenant une lame plane et des moyens pour faire avancer la lame plane suivant une direction d'avance dans un plan de séparation correspondant au plan moyen de la zone fragile ou un plan parallèle à un plan de la zone de maintien, depuis un bord d'entrée de la structure en direction d'un bord de sortie de la structure, en sorte de provoquer une séparation progressive des deux sous-structures, le dispositif étant caractérisé en ce qu'il comprend des moyens pour faire varier l'inclinaison de la lame dans le plan de séparation vis-à-vis de la direction d'avance.

Selon une caractéristique optionnelle, lesdits moyens pour faire varier l'inclinaison de la lame dans le plan de séparation vis-à-vis de la direction d'avance permettent de faire varier ladite inclinaison dans un sens et dans le sens opposé.

Selon une caractéristique optionnelle, des moyens pour faire avancer une lame plane suivant une direction d'avance comprennent un rail de guidage.

Selon une caractéristique optionnelle, la lame comporte un bord d'attaque entre deux extrémités, un évidement oblong s'étendant transversalement à la direction d'avance et étant situé à proximité de chaque extrémité, ladite lame étant reliée à deux rails linéaires parallèles entre eux, par l'intermédiaire de tiges engagées dans les évidements oblongs.

La liberté de mouvement de la tige dans le trou oblong permet d'appliquer à la lame un mouvement de rotation dans son plan ou un mouvement de translation dans la direction d'allongement du trou oblong.

Selon une caractéristique optionnelle, la lame est reliée à des rails par l'intermédiaire de bras de longueurs variables.

Selon une caractéristique optionnelle, la lame a une épaisseur au plus égale à 100 µm.

Selon une caractéristique optionnelle, la lame a une épaisseur au moins égale à 50 µm.

Selon une caractéristique optionnelle, la lame est flexible.

Selon une caractéristique optionnelle, un déplacement de ladite lame est provoqué par un moteur enroulant la lame à une extrémité de la lame.

Selon une caractéristique optionnelle, la lame comprend de l'aluminium.

Selon une caractéristique optionnelle, la lame comprend un film plastique.

Selon une caractéristique optionnelle, la lame comprend du Kapton®.

Selon une caractéristique optionnelle, la lame comprend du papier.

Selon une caractéristique optionnelle, la lame comprend un matériau composite comme de la fibre de carbone.

Selon une caractéristique optionnelle, un bord d'attaque de la lame est biseauté.

Cela permet d'engager la lame facilement dans la structure à couper au niveau du plan de séparation, et de minimiser la concentration de contraintes auprès du front de séparation.

Alternativement un bord d'attaque de la lame peut être arrondi.

Selon une caractéristique optionnelle, le dispositif comporte en outre une platine aspirante permettant de maintenir la structure par aspiration.

Selon une caractéristique optionnelle, il comporte en outre une caméra par exemple infra-rouge pour visionner la structure par exemple suivant une direction perpendiculaire au plan d'application.

La caméra permet de visualiser la progression du front de séparation entre les deux sous-structures.

Selon une caractéristique optionnelle, le dispositif comprend en outre des moyens d'asservissement du mouvement de la lame à un signal issu de la caméra.

Le mouvement peut n'être asservi que dans sa composante de rotation ou dans sa composante de translation.

Selon une caractéristique optionnelle, la platine aspirante est réglable en hauteur et en inclinaison.

Cela permet de pouvoir déplacer la structure à séparer jusqu'à une position où la lame est présentée au niveau de la zone de maintien.

Des objets, caractéristiques et avantages de l'invention ressortent de la description qui suit, donnée à titre d'exemple illustratif non limitatif, en regard des dessins annexés sur lesquels :
La figure 1 est une vue schématique en coupe d'une structure constituée de deux plaques collées l'une à l'autre et d'une lame appliquée entre les deux plaques selon une méthode de décollement de l'art antérieur.
La figure 2 est une vue de la même structure et de la même lame dans la même position, mais vues du dessus.
La figure 3 est une vue de dessus d'une structure à laquelle, une lame principale et deux lames secondaires sont appliquées dans un plan de la structure, selon une autre méthode de l'art antérieur.
La figure 4 est une vue de côté d'une structure constituée de deux plaques collées et d'une lame appliquée entre les deux plaques, selon l'art antérieur, l'une des plaques étant fine par rapport à la lame et à l'autre plaque.
La figure 5 est une vue schématique du dessus d'une structure dans un plan de laquelle une lame est appliquée, la lame étant proche d'un bord d'entrée de la structure au début de la mise en oeuvre d'un procédé selon l'invention.
La figure 6 en est une vue analogue, après un premier déplacement de la lame.
La figure 7 en est une autre vue analogue, après un nouveau déplacement de la lame, la lame progressant dans la structure.
La figure 8 en est une autre vue analogue, après un nouveau déplacement de la lame, la lame étant proche d'un bord de sortie de la structure.
La figure 9 est une vue schématique du dessus d'une structure dans un plan de laquelle une lame est appliquée, au début de la mise en oeuvre d'un deuxième mode de réalisation d'un procédé selon l'invention.
La figure 10 en est une vue analogue, après un déplacement de la lame à partir de la configuration de la figure 9.
La figure 11 en est une vue analogue, après un nouveau déplacement de la lame.
La figure 12 est une vue montrant un phénomène de recollement lors de l'utilisation de procédé de l'art antérieur.
La figure 13 est une vue d'une lame dans le cadre d'une variante de l'invention.
La figure 14 est une vue d'une autre lame dans le cadre d'une autre variante de l'invention.
La figure 15 est une vue de dessus d'une lame d'un dispositif de séparation selon un mode de réalisation de l'invention.
La figure 16 est une vue schématique de dessus d'un dispositif de séparation selon un mode de réalisation de l'invention.
La figure 17 est une vue de dessus d'un dispositif de séparation selon un mode de réalisation de l'invention.
La figure 18 en est une vue schématique de côté du dispositif de la figure 16.
La figure 19 est une vue schématique de côté d'un autre dispositif de séparation selon l'invention.
La figure 20 est une vue de dessus d'une autre lame d'un dispositif de séparation selon un autre mode de réalisation de l'invention.
Les figures 21 à 24 sont des vues en coupe, des bords d'attaque de quatre lames pouvant servir pour la mise en oeuvre d'un procédé selon l'invention.
Les figures 25 à 27 sont des vues en coupe des bords d'attaque de trois systèmes de lames pouvant servir pour la mise en oeuvre d'un procédé selon l'invention.
La figure 28 est une vue schématique en coupe d'une application d'un procédé selon l'invention à la séparation d'une structure composée de deux sous-structures, dont l'une est plus fine que l'autre.
La figure 29 en est une vue de dessus.
La figure 30 est une vue schématique en coupe d'une application d'un procédé selon l'invention à la séparation d'une structure composée de deux sous-structures, dont l'une comporte une bordure périphérique épaisse autour d'une portion centrale plus fine, avant engagement d'une lame.
La figure 31 en est une vue analogue, après engagement de la lame.

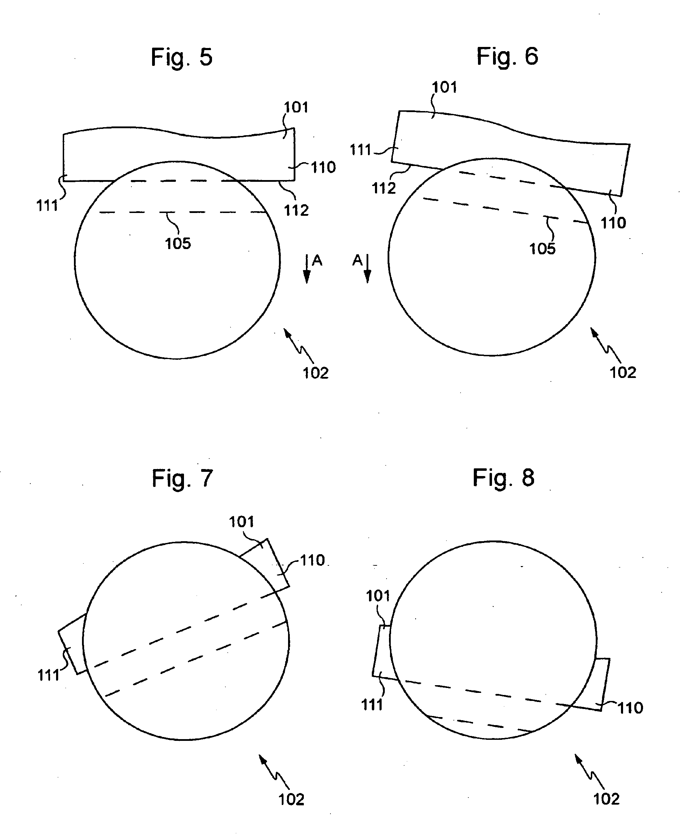

En référence à la figure 5, une structure 102 cylindrique par exemple de silicium composée de deux plaques collées l'une sur l'autre (de manière similaire à la structure présentée en figure 1), est disposée horizontalement. En variante, il s'agit d'une structure comportant une zone poreuse ou une zone fragile enterrée obtenue par implantation d'une ou plusieurs espèces gazeuses et délimitant deux sous-structures à séparer.

Une lame 101 est insérée dans le plan de l'interface de collage des deux plaques, par un bord de cette interface ici qualifié de bord d'entrée, au contact des deux plaques. La lame présente, schématiquement, deux extrémités latérales 110 et 111, et un bord d'attaque 112 ici rectiligne. Celui-ci est ici disposé perpendiculairement à un rayon de la structure 102 (non représenté).

Un front de décollement 105 s'établit essentiellement parallèle au bord d'attaque 112, en avant de celui-ci, entre les deux plaques de la structure 102. Ce front de décollement 105, ici assimilable à une courbe et plus précisément à une droite, est le lieu où les matières désolidarisées des deux plaques se rejoignent.

En référence à la figure 6, la lame 101 est avancée selon une direction d'avance générale A, entre les deux plaques de la structure 102, dans le plan de l'interface.

L'extrémité 110 de la lame progresse, selon la direction d'avance A, selon une distance supérieure à celle de l'extrémité 111. L'inclinaison générale de la lame dans son plan par rapport à la direction générale d'avance a ainsi été modifiée.

Le front de décollement 105 a progressé, toujours en avant du bord d'attaque 112. Il s'est déplacé vers une désolidarisation plus importante des deux plaques, la surface de la zone ouverte augmentant et la surface de la zone fermée diminuant.

En référence à la figure 7, la lame 101 est à nouveau avancée selon la direction générale d'avance A, entre les deux plaques de la structure 102, dans le plan de l'interface. L'extrémité 110 de la lame a progressé selon une distance moindre que l'extrémité 111, l'inclinaison générale de la lame dans son plan ayant ainsi été à nouveau modifiée.

Enfin en référence à la figure 8, la lame 101 est à nouveau avancée selon la direction générale d'avance A, entre les deux plaques, dans le plan de l'interface. L'extrémité 110 a progressé selon une plus grande distance que l'extrémité 111, l'inclinaison générale de la lame ayant ainsi été modifiée.

La lame est à ce stade à proximité du bord de la structure 102 opposé au bord d'entrée, un bord qualifié de bord de sortie, par lequel la lame peut sortir de la structure 102.

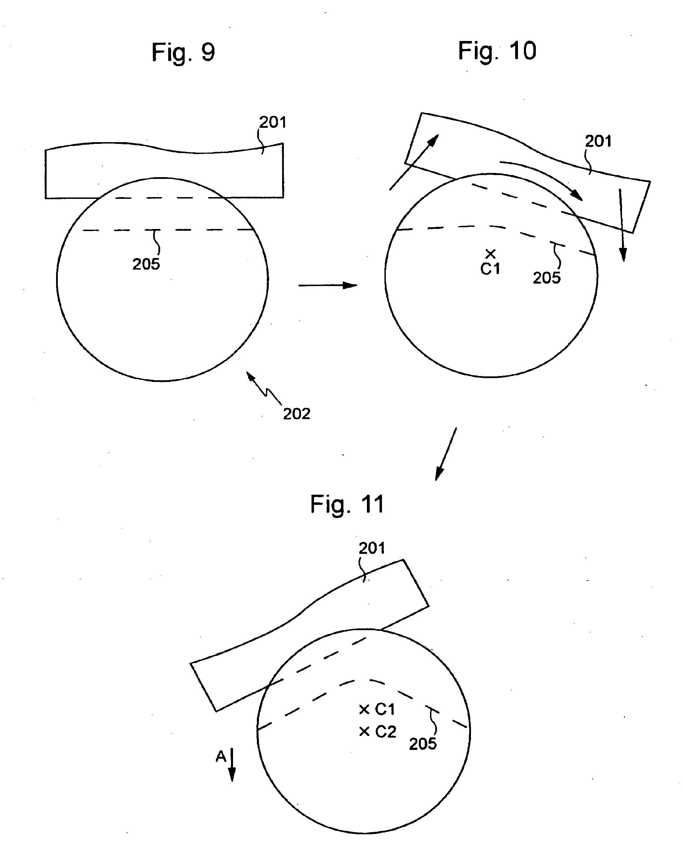

Un deuxième mode de réalisation d'un procédé selon l'invention est présenté maintenant aux figures 9 à 11.

En référence à la figure 9, une structure cylindrique 202 composée de deux plaques est disposée de la même manière qu'en figure 5, une lame 201 étant insérée dans le plan de l'interface de collage des deux plaques, et un front de décollement 205 s'étant établi en avant du bord d'attaque de la lame.

En référence à la figure 10, la lame 201 a suivi un mouvement de rotation dans son plan. La rotation est effectuée autour d'un centre de rotation C1 situé par exemple à l'aplomb de la structure 202, à proximité de son centre dans le sens des aiguilles d'une montre. D'autres positions sont bien sûr possibles pour C1 : C1 peut par exemple se situer au niveau de la lame.

Le front de décollement 205 s'est déplacé sur une partie de sa longueur, et a pris une forme incurvée, la zone encore collée étant convexe, et la zone décollée, de surface plus grande qu'en figure 9, étant concave.

En référence à la figure 11, la lame 201 a suivi, depuis la configuration de la figure 10, une nouvelle rotation dans son plan. La rotation est effectuée autour d'un centre de rotation C2, dans le sens contraire des aiguilles d'une montre. Le centre C2 s'obtient, dans le mode de réalisation présenté, à partir du centre de rotation C1 par une translation dans la direction d'avancée A.

Le front de décollement s'est déplacé sur une partie de sa longueur et sa courbure s'est modifié. La surface décollée est plus grande que dans la configuration de la figure 10.

La séparation de la structure 202 continue ensuite par exemple par une translation de la lame 201 suivant la direction d'avance A, avec ou sans nouvelle variation de l'inclinaison de la lame dans son plan.

Selon une variante, le mouvement de rotation peut être réalisé avant et/ou en même temps que le mouvement de translation dans la direction d'avance. Il peut être associé à un mouvement de translation perpendiculairement à la direction d'avance.

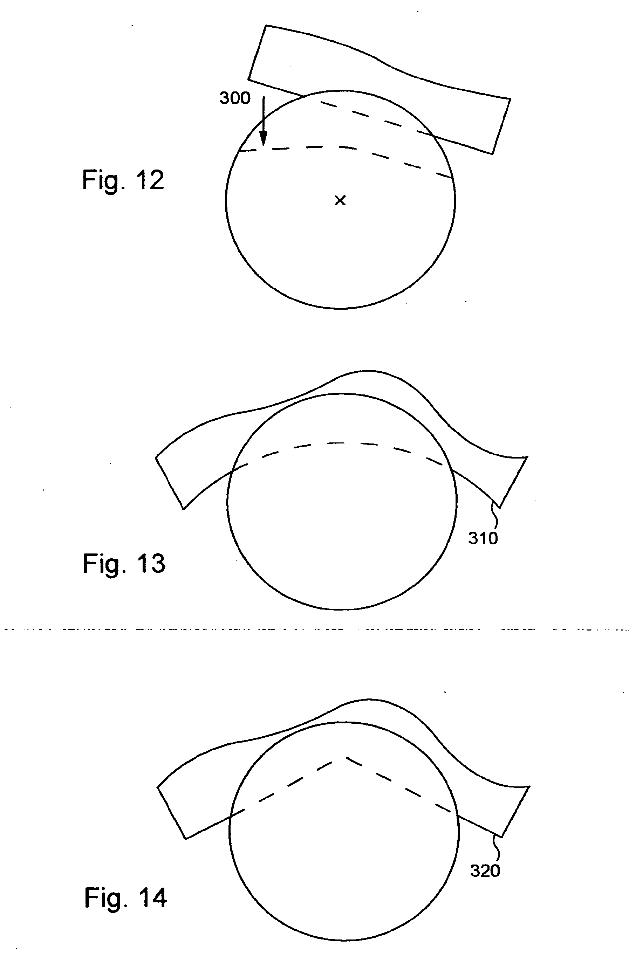

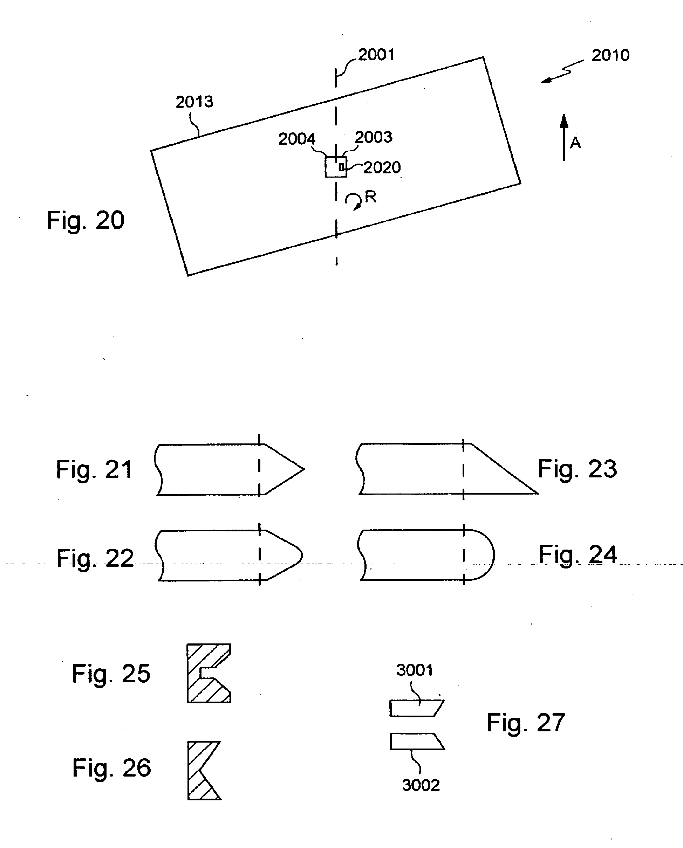

En référence aux figures 12 à 14, on notera qu'une partie des zones décollées peut se recoller, par exemple dans une zone 300. Pour limiter ce phénomène, il est avantageux d'utiliser une lame présentant un bord d'attaque courbe, par exemple un bord d'attaque convexe 310 ou un bord d'attaque anguleux 320 ou même un bord d'attaque en plusieurs morceaux non continus (comme illustré figure 25), voire plusieurs lames (comme illustré figure 27).

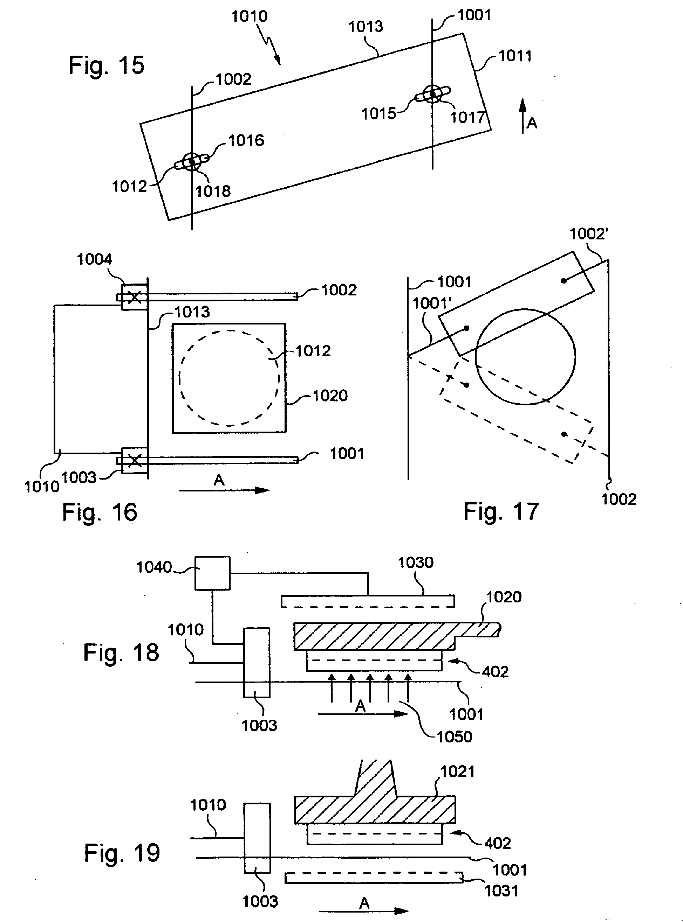

En figures 15 à 18, un dispositif de séparation selon un premier mode de réalisation de l'invention est présenté.

En référence à la figure 15, il comprend deux rails 1001 et 1002 parallèles l'un à l'autre, ainsi qu'une lame 1010 plane, dont le plan est parallèle aux deux rails.

La lame est allongée transversalement aux deux rails entre deux extrémités 1011 et 1012, et comporte un bord d'attaque 1013 allongé selon la direction d'allongement de la lame.

La lame est perforée de manière à être entrainée sur les rails, selon une direction d'avance A parallèle aux rails, par deux moteurs (non représentés) fonctionnant indépendamment l'un de l'autre.

La perforation est réalisée sous la forme de trous oblongs 1015 et 1016, proches des deux extrémités 1011 et 1012 de la lame et traversant la lame perpendiculairement à son plan.

Des fixations (par exemple des boulons), constituant des tiges 1017 et 1018 insérées dans les trous oblongs relient la lame à chaque rail et au moteur correspondant.

Ce mode de fixation permet à la lame de suivre un mouvement de rotation par rapport aux rails, autour d'un axe perpendiculaire à son plan, et donc de faire varier son inclinaison dans son plan. Le mouvement de rotation par rapport aux rails peut être combiné, ou non, à un mouvement général de translation dans la direction d'avance A.

En référence à la figure 16, le dispositif de séparation inclut la lame 1010 et les rails 1001 et 1002 sur lesquels la lame 1010 est montée, ainsi que des moteurs 1003 et 1004 entraînant la lame 1010 sur les rails, selon la direction générale d'avance A.

Les deux moteurs sont ici réglables par un utilisateur, mais ils pourraient aussi être commandés par un ordinateur. De manière importante, ils sont réglables indépendamment l'un de l'autre, ce qui permet de faire varier l'inclinaison du bord d'attaque 1013 dans le plan de la lame.

Une platine aspirante 1020 est placée entre les rails, de manière à recouvrir une structure cylindrique, par exemple en silicium, présentée à la lame 1010, et à maintenir cette structure par aspiration pendant l'opération de séparation.

Cette platine aspirante est avantageusement au moins partiellement transparente aux rayons infrarouge et/ou visible afin de permettre une observation au cours de la séparation : elle peut être évidée, et/ou constituée principalement en verre. Elle pourrait également être en plexiglas ou en quartz par exemple.

On note enfin que la lame 1010 possède une largeur, dans le sens de la direction d'avance A, telle qu'elle est en mesure de recouvrir entièrement la structure à séparer pendant l'opération de séparation.

En référence à la figure 17, selon une variante, la lame est solidaire des rails 1001 et 1002 via des bras 1001' et 1002' dont la longueur est variable.

En référence à la figure 18, le dispositif de séparation de la figure 16 est représenté selon une vue de côté. Une structure 402, composée de deux sous-structures, ici en silicium, est placée sous la platine aspirante 1020.

La platine aspirante maintient l'une des sous-structures, par exemple la plus épaisse des deux, ou alternativement la plus fine.

Le rail 1001, ainsi que le rail 1002 (non représenté), combiné au moteur 1003 et au moteur 1004 (non représenté), permet de faire avancer la lame 1010 selon la direction générale d'avance A.

La platine aspirante 1020 est réglable en hauteur et en inclinaison par l'intermédiaire de vernier et de vis micrométriques, permettant d'appliquer la lame 1010 parallèlement au plan de séparation des deux sous-structures de la structure 402.

Une caméra infra-rouge 1030 est disposée en regard de la structure 402, de manière à la visualiser selon une direction perpendiculaire au plan de la structure 402, à travers la platine aspirante 1020, qui, dans le mode de réalisation décrit, est transparente aux ondes infra-rouges ou évidée, un éclairage infrarouge 1050 pouvant être disposé par exemple sous la structure 402.

La caméra infra-rouge 1030 est ainsi en position pour visualiser un front de décollement se formant entre les deux sous-structures de la structure 402, ainsi que son déplacement.

Les signaux mesurés par la caméra infra-rouge 1030 sont utilisés par un calculateur 1040 pour asservir les mouvements des moteurs 1003 et 1004, indépendamment l'un de l'autre, en sorte de faire varier l'inclinaison de la lame 1010 dans son plan en fonction du déplacement du front de décollement observé entre les deux sous-structures de la structure 402.

Selon un autre mode de réalisation d'un dispositif de séparation selon l'invention, représenté en figure 19, la structure 402 est placée sous une platine aspirante 1021, et une caméra infra-rouge 1031 est installée sous la structure 402, à l'opposé de la platine aspirante 1021.

Un moteur 1003 contrôle comme précédemment le déplacement de la lame 1010 sur le rail 1001, et un deuxième moteur 1004 (non représenté) contrôle le déplacement de la lame 1010 sur le rail 1002 (non représenté) de telle sorte que la lame avance globalement suivant la direction générale d'avance A, et que son inclinaison est variée dans son plan, permettant ainsi une séparation contrôlée de la structure 402.

Un autre mode de réalisation d'un système de lame pour la mise en oeuvre d'un procédé selon l'invention est présenté en figure 20.

Il comporte un rail 2001 rectiligne et une lame 2010 plane parallèle au rail 2001. La lame est fixée au rail selon un axe 2020 perpendiculaire au plan de la lame. Un moteur 2003 permet d'entraîner la lame en translation sur le rail selon une direction générale d'avance A. La lame présente de plus un bord d'attaque 2013.

Un moteur 2004 et une liaison pivot d'axe 2020 permet à la lame de suivre de plus un mouvement de rotation R dans son plan par rapport au rail 2001, ce qui a pour conséquence de faire varier son inclinaison dans son plan.

En référence aux figures 21 à 24, différents profils de bord d'attaque de lames utilisées pour la mise en oeuvre d'un procédé selon l'invention avec un dispositif selon l'invention sont présentées.

En figure 21, un bord d'attaque de lame pointue est présenté : le bord d'attaque comporte deux surfaces planes convergeant l'une vers l'autre et formant un angle. Le bord de la lame est donc anguleux, du moins quand il est observé à l'échelle de la lame.

En figure 22, un bord d'attaque de lame partiellement arrondi est présenté : il comporte deux surfaces planes convergeant l'une vers l'autre, mais qui s'arrondissent juste avant de se rejoindre.

En figure 23, on a représenté un bord d'attaque biseauté,

En figure 24, un bord d'attaque de lame entièrement arrondi est présenté.

En figures 25 à 27 sont représentés d'autres bords d'attaque de lame utilisés selon des variantes. Le bord d'attaque peut être courbe (concave ou convexe) ou anguleux. Deux lames 3001 et 3002 ayant des directions d'avance identiques sont utilisées selon une variante.

Le procédé selon l'invention est mis en oeuvre indifféremment avec chacune de ces lames, qui se prêtent particulièrement bien au contrôle fin de l'opération de séparation.

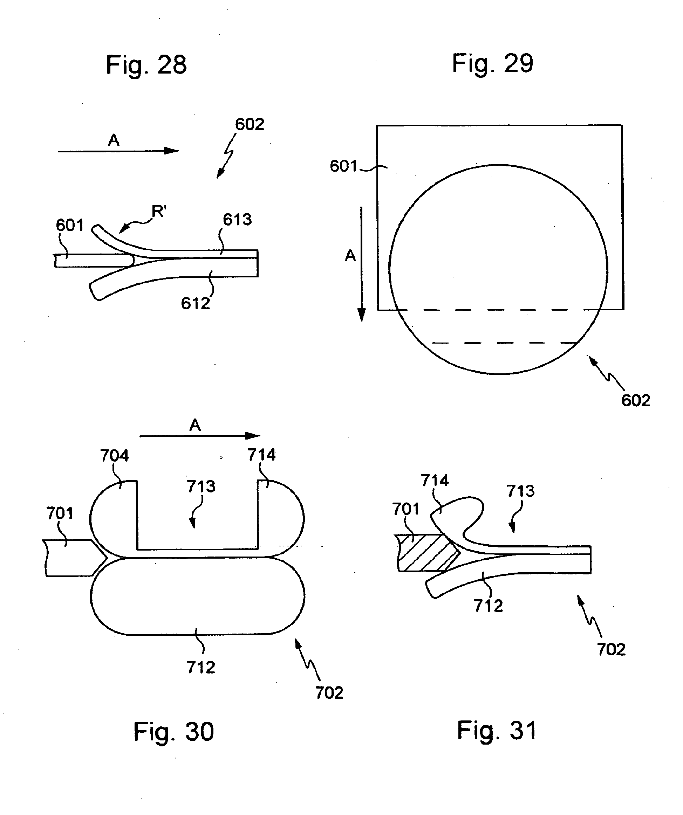

En référence aux figures 28 et 29, est représentée une application d'un procédé selon l'invention pour la séparation d'une structure 602 composée de deux plaques 612 et 613 de diamètre de l'ordre de 20 cm.

Une des plaques est une plaque épaisse 612, alors que l'autre est une plaque fine 613, dont l'épaisseur est de moins de 50 µm, ici 35 µm. L'énergie de collage entre les plaques est de l'ordre de 350 mJ/m².

La séparation est effectuée à l'aide d'une lame 601 de 25 cm de longueur parallèlement à son bord d'attaque, en aluminium. La longueur de la lame est essentiellement fonction de la largeur de la structure à séparer.

La lame utilisée possède de plus une épaisseur de 50 microns, et une largeur dans son plan, perpendiculairement au bord d'attaque, supérieure à la dimension des plaques 612 et 613. La lame est manipulée par le dispositif présenté en figures 17 et 18.

La lame 601 avance suivant une direction générale d'avance A, avec une inclinaison dans son plan qui varie, ici suivant le mode de réalisation du procédé présenté en figures 5 à 8.

Au cours d'une étape d'inclinaison de la lame dans son plan, l'une des extrémités de la lame, montée sur un premier moteur, avance à une vitesse de 1 mm.min⁻¹, et l'autre extrémité de la lame, montée sur un deuxième moteur avance à une vitesse de 1 cm.min⁻¹.

On voit en figure 28 que la lame 601, de faible épaisseur, impose une courbure peu prononcée à la plaque 613 (d'où un rayon de courbure R' élevé), compte tenue de l'épaisseur de la plaque 613.

Par ailleurs, la variation de l'inclinaison de la lame 601 induit une variation de la répartition des efforts exercés par la lame sur la structure, ce qui permet un bon contrôle de la progression de la lame 601.

Cela permet un bon contrôle de la séparation, et l'obtention de surfaces séparées de bonne qualité.

On voit de plus en figure 29 que, la largeur de la lame 601 perpendiculairement à son bord d'attaque est telle que, même quand la lame 601 s'approche du bord de sortie de la structure 602, la lame s'interpose entre les plaques 612 et 613 sur toute la surface de leur interface. Cela permet de supprimer tout risque de recollement des deux plaques 612 et 613 l'une à l'autre, au cours de l'opération de séparation.

La plaque 613 est alors utilisable pour diverses applications notamment dans le domaine de la micro-électronique. C'est également le cas de la plaque 612.

En référence aux figures 30 et 31, une deuxième application du procédé selon l'invention est représentée. Elle porte sur la séparation d'une structure 702 composée de deux plaques circulaires 712 et 713, l'une étant une plaque épaisse 712, et l'autre une plaque fine 713 possédant une partie épaisse 714 en périphérie, le long de sa circonférence.

Une telle plaque fine 713 possédant une partie épaisse 714 en périphérie peut être obtenue par amincissement d'une plaque initialement épaisse, l'amincissement étant pratiqué sur une surface centrale de la plaque, perpendiculairement à celle-ci.

Dans le cas décrit, l'amincissement a été réalisé de manière mécanique, mais il peut aussi être réalisé de manière chimique (par gravure chimique), ou selon une combinaison de moyens mécaniques et chimiques.

Une lame 701 fine est utilisée. Son bord d'attaque est biseauté. Par ailleurs, les plaques 712 et 713 possèdent un chanfrein au niveau de leur circonférence. Ainsi, la forme de la lame et la forme de la structure facilitent le guidage de la lame depuis l'extérieur de la structure vers l'interface reliant les plaques 712 et 713.

Selon le procédé représenté en figures 30 et 31, la lame 701 est appliquée à la zone de maintien, ou l'interface de collage, entre les plaques 712 et 713, provoquant leur séparation locale. Un front de séparation s'établit en avant de la lame 701. La lame avance alors suivant une direction générale d'avance A, l'inclinaison de la lame dans son plan étant modifiée au cours de l'avancée, comme expliqué plus haut.

Grâce à ce procédé, la séparation de la structure composée des plaques 712 et 713 est contrôlée, et le risque de cassure de la structure 713 est limité, la lame 701 utilisée étant fine. Il en résulte une séparation globalement de bonne qualité, permettant l'utilisation de la plaque 713 pour diverses applications par exemple dans le domaine de la micro-électronique.

## Revendications

1. Procédé de séparation d'une structure (102 ; 202 ; 402 ; 602 ; 702) comprenant une zone fragile délimitant dans cette structure deux sous-structures à séparer,
selon lequel on fait avancer au moins une lame plane (101 ; 201 ; 1010 ; 2010 ; 601 ; 701) suivant une direction d'avance (A) dans un plan de séparation correspondant à un plan moyen de la zone fragile, depuis un bord d'entrée de la structure en direction d'un bord de sortie de la structure, en sorte de provoquer une séparation progressive des deux sous-structures,
le procédé étant **caractérisé en ce qu'**on fait varier l'inclinaison de la lame dans le plan de séparation vis-à vis de la direction d'avance.

2. Procédé selon la revendication 1, **caractérisé en ce qu'**on fait avancer la lame par des tractions appliquées à des portions latérales de la lame.

3. Procédé selon la revendication 1 ou la revendication 2, **caractérisé en ce qu'**on fait varier l'inclinaison de la lame en la faisant tourner autour d'un centre instantané de rotation situé dans le plan de séparation.

4. Procédé selon l'une quelconque des revendications 1 à 3 **caractérisé en ce qu'**on fait avancer ladite lame également suivant une direction perpendiculaire à la direction d'avance.

5. Procédé selon l'une quelconque des revendications 1 à 4 **caractérisé en ce qu'**on fait varier l'inclinaison alternativement dans un sens et dans l'autre, au fur et à mesure de l'avance de la lame.

6. Procédé selon l'une quelconque des revendications 1 à 5, **caractérisé en ce que** la zone fragile est une interface de collage entre une surface d'une première des deux sous-structures et une surface de la deuxième des deux sous-structures.

7. Procédé selon l'une quelconque des revendications 1 à 6, **caractérisé en ce que** la zone fragile est une zone mécaniquement affaiblie par une modification physique, chimique ou physico-chimique subie par un constituant de ladite zone de la structure.

8. Procédé selon l'une quelconque des revendications 1 à 7, **caractérisé en ce que** la zone fragile est une interface de dépôt.

9. Procédé selon l'une quelconque des revendications 1 à 8, **caractérisé en ce que** la zone fragile est une zone poreuse.

10. Procédé selon l'une quelconque des revendications 1 à 9, **caractérisé en ce que** la zone fragile est une zone obtenue par implantation d'espèces gazeuses.

11. Procédé selon l'une quelconque des revendications 1 à 10, **caractérisé en ce qu'**une des deux sous-structures (613 ; 713) a une épaisseur inférieure à 50 µm, mesurée perpendiculairement audit plan d'application.

12. Procédé selon l'une quelconque des revendications 1 à 11, **caractérisé en ce que** le bord d'attaque de la lame est linéaire, courbe ou anguleux.

13. Procédé selon l'une quelconque des revendications 1 à 12, **caractérisé en ce que** le bord d'attaque est discontinu.

14. Procédé selon l'une quelconque des revendications 1 à 13 **caractérisé en ce que** la lame s'étend dans son plan, parallèlement à la direction d'avance, de telle sorte qu'elle reste interposée entre les deux sous-structures tout au long du procédé de séparation.

15. Procédé selon l'une quelconque des revendications 1 à 14, **caractérisé en ce qu'**une platine aspirante assure le maintien en position de la structure par application d'une aspiration sur une surface libre de cette structure.

16. Procédé selon l'une quelconque des revendications 1 à 15, **caractérisé en ce que** le mouvement d'inclinaison de ladite lame est asservi à un signal issu d'une caméra, par exemple infra-rouge, filmant la structure.

17. Procédé selon l'une quelconque des revendications 1 à 16, **caractérisé en ce que** l'une des sous-structures présente, suivant une direction parallèle au plan de séparation, depuis le bord vers l'intérieur de la structure, une zone d'épaisseur maximale (714) puis une zone d'épaisseur minimale significativement plus faible que l'épaisseur de la zone d'épaisseur maximale (713), l'épaisseur étant mesurée perpendiculairement au plan de séparation.

18. Dispositif de séparation d'une structure comprenant une zone fragile délimitant au sein de ladite structure deux sous-structures,
le dispositif comprenant une lame plane (1010 ; 2010) et des moyens (1001, 1002, 1003, 1004 ; 1001', 1002' ; 2001, 2003) pour faire avancer la lame plane suivant une direction d'avance (A) dans un plan de séparation correspondant au plan moyen de la zone fragile, depuis un bord d'entrée de la structure en direction d'un bord de sortie de la structure, en sorte de provoquer une séparation progressive des deux sous-structures,
le dispositif étant **caractérisé en ce qu'**il comprend des moyens (1003, 1004, 1015, 1016, 1017, 1018; 2004, 2020; 1001', 1002') pour faire varier l'inclinaison de la lame dans le plan de séparation vis-à-vis de la direction d'avance.

19. Dispositif suivant la revendication 18 **caractérisé en ce que** lesdits moyens pour faire varier l'inclinaison de la lame dans le plan de séparation vis-à-vis de la direction d'avance permettent de faire varier ladite inclinaison dans un sens et dans le sens opposé.

20. Dispositif selon la revendication 18 ou la revendication 19, **caractérisé en ce que** les moyens pour faire avancer la lame plane suivant une direction d'avance comprennent un rail de guidage (1001, 1002 ; 2001).

21. Dispositif selon la revendication 20, **caractérisé en ce que** la lame comporte un bord d'attaque entre deux extrémités, un évidement oblong (1015, 1016) s'étendant transversalement à la direction d'avance et étant situé à proximité de chaque extrémité, ladite lame étant reliée à deux rails linéaires (1001, 1002) parallèles entre eux par l'intermédiaire de tiges (1017, 1018) engagées dans les évidements oblongs.

22. Dispositif selon l'une des revendications 18 à 21, **caractérisé en ce que** la lame est reliée à des rails par l'intermédiaire de bras de longueurs variables (1001', 1002').

23. Dispositif selon l'une des revendications 18 à 22, **caractérisé en ce que** la lame a une épaisseur au plus égale à 100 µm.

24. Dispositif selon l'une quelconque des revendications 18 à 23, **caractérisé en ce qu'**un bord d'attaque (1013 ; 2013) de la lame est biseauté.

25. Dispositif selon l'une quelconque des revendications 18 à 24, **caractérisé en ce qu'**il comporte en outre une platine aspirante (1020 ; 1021) permettant de maintenir la structure par aspiration.

26. Dispositif selon la revendication 25, **caractérisé en ce qu'**l comporte en outre une caméra, par exemple infra-rouge, (1030 ; 1031) pour visionner la structure.

27. Dispositif selon la revendication 26, **caractérisé en ce que** le dispositif comprend en outre des moyens d'asservissement (1040) du mouvement de la lame à un signal issu de la caméra.

## Claims

1. Method of separating a structure (102; 202; 402 ; 603; 702) including a fragile zone delimiting in that structure two substructures to be separated,
wherein at least one plane blade (101; 201; 1010; 2010; 601 ; 701) is advanced in a direction of advance (A) in a separation plane corresponding to a median plane of the fragile zone, from an entry edge of the structure in the direction of an exit edge of the structure, so as to cause progressive separation of the two substructures,
the method being **characterised in that** the inclination of the blade in the separation plane relative to the direction of advance is varied.

2. Method according to claim 1, **characterised in that** the blade is advanced by applying traction to lateral portions of the blade.

3. Method according to claim 1 or claim 2, **characterised in that** the inclination of the blade is varied by causing it to turn about an instantaneous center of rotation situated in the separation plane.

4. Method according to any one of claims 1 to 3, **characterised in that** said blade is also advanced in a direction perpendicular to the direction of advance.

5. Method according to any one of claims 1 to 4, **characterised in that** the inclination is varied alternately in one direction and the other, as the blade advances.

6. Method according to any one of claims 1 to 5, **characterised in that** the fragile zone is a bonding interface between a surface of a first of the two substructures and a surface of the second of the two substructures.

7. Method according to any one of claims 1 to 6, **characterised in that** the fragile zone is a zone mechanically weakened by physical and/or chemical modification to which a constituent of said zone of the structure is subjected.

8. Method according to any one of claims 1 to 7, **characterised in that** the fragile zone is a deposition interface.

9. Method according to any one of claims 1 to 8, **characterised in that** the fragile zone is a porous zone.

10. Method according to any one of claims 1 to 9, **characterised in that** the fragile zone is a zone obtained by implantation of gaseous species.

11. Method according to any one of claims 1 to 10, **characterised in that** one of the two substructures (613; 713) has a thickness less than 50 µm measured perpendicularly to said plane of application.

12. Method according to any one of claims 1 to 11, **characterised in that** the leading edge of the blade is linear, curved or angular.

13. Method according to any one of claims 1 to 12, **characterised in that** the leading edge is discontinuous.

14. Method according to any one of claims 1 to 13, **characterised in that** the blade lies in its plane, parallel to the direction of advance, so that it remains between the two substructures throughout the separation process.

15. Method according to any one of claims 1 to 14, **characterised in that** a suction plate holds the structure in position by application of suction to a free surface of the structure.

16. Method according to any one of claims 1 to 15, **characterised in that** the movement of inclination of said blade is slaved to a signal from a video camera, for example an infrared video camera, filming the structure.

17. Method according to any one of claims 1 to 16, **characterised in that** one of the substructures has, in a direction parallel to the separation plane, from the edge towards the interior of the structure, a zone (714) of maximum thickness and then a zone (713) of minimum thickness significantly thinner than the zone of maximum thickness, the thickness being measured perpendicularly to the separation plane.

18. Device for separating a structure including a fragile zone delimiting two substructures within said structure,
the device including a plane blade (1010; 2010) and means (1001, 1002, 1003, 1004; 1001', 1002'; 2001, 2003) for advancing the plane blade in a direction of advance (A) in a separation plane corresponding to the median plane of the fragile zone, from an entry edge of the structure in the direction of an exit edge of the structure, to cause progressive separation of the two substructures,
the device being **characterised in that** it includes means (1003, 1004, 1015, 1016, 1017, 1018; 2004, 2020; 1001', 1002') for varying the inclination of the blade in the separation plane relative to the direction of advance.

19. Device according to claim 18, **characterised in that** said means for varying the inclination of the blade in the separation plane relative to the direction of advance vary said inclination in one direction and in the opposite direction.

20. Device according to claim 18 or claim 19, **characterised in that** the means for advancing the plane blade in a direction of advance include a guide rail (1001, 1002; 2001).

21. Device according to claim 20, **characterised in that** the blade has a leading edge between two ends, an oblong opening (1015, 1016) extending transversely to the direction of advance and situated in the vicinity of each end, said blade being connected to two parallel linear rails (1001, 1002) by rods (1017, 1018) engaged in the oblong openings.

22. Device according to any one of claims 18 to 21, **characterised in that** the blade is connected to the rails by arms (1001', 1002') of variable length.

23. Device according to any one of claims 18 to 22, **characterised in that** the blade has a thickness at most equal to 100 µm.

24. Device according to any one of claims 18 to 23, **characterised in that** a leading edge (1013; 2013) of the blade is bevelled.

25. Device according to any one of claims 18 to 24, **characterised in that** it further includes a suction plate (1020; 1021) for retaining the structure by suction.

26. Device according to claim 25, **characterised in that** it further includes a video camera (1030; 1031), for example an infrared video camera, for viewing the structure.

27. Device according to claim 26, **characterised in that** the device further includes means (1040) for slaving the movement of the blade to a signal from the video camera.

## Patentansprüche

1. Verfahren zum Trennen einer Struktur (102; 202; 402; 602; 702), umfassend eine fragile Zone, die in dieser Struktur zwei zu trennende Unterstrukturen abgrenzt,
gemäß welchem man mindestens eine ebene Klinge (101; 201; 1010; 2010; 601; 701) in einer Vorschubrichtung (A) in einer Trennebene, die einer Mittelebene der fragilen Zone entspricht, von einem Eintrittsrand der Struktur aus in Richtung eines Austrittsrands der Struktur sich so vorbewegen lässt, dass eine allmähliche Trennung der beiden Unterstrukturen bewirkt wird,
wobei das Verfahren **dadurch gekennzeichnet ist, dass** man die Neigung der Klinge in der Trennebene gegenüber der Vorschubrichtung sich ändern lässt.

2. Verfahren nach Anspruch 1, **dadurch gekennzeichnet, dass** man die Klinge durch Züge sich vorbewegen lässt, die an seitliche Abschnitte der Klinge angelegt werden.

3. Verfahren nach Anspruch 1 oder Anspruch 2, **dadurch gekennzeichnet, dass** man die Neigung der Klinge sich ändern lässt, indem man sie sich um einen in der Trennebene gelegenen momentanen Drehungsmittelpunkt drehen lässt.

4. Verfahren nach einem der Ansprüche 1 bis 3, **dadurch gekennzeichnet, dass** man die Klinge auch in einer zur Vorschubrichtung senkrechten Richtung sich vorbewegen lässt.

5. Verfahren nach einem der Ansprüche 1 bis 4, **dadurch gekennzeichnet, dass** man die Neigung abwechselnd in einem Sinn und im anderen im Maße der Vorbewegung der Klinge sich ändern lässt.

6. Verfahren nach einem der Ansprüche 1 bis 5, **dadurch gekennzeichnet, dass** die fragile Zone eine Verklebungstrennfläche zwischen einer Fläche einer ersten der beiden Unterstrukturen und eine Fläche der zweiten der beiden Unterstrukturen ist.

7. Verfahren nach einem der Ansprüche 1 bis 6, **dadurch gekennzeichnet, dass** die fragile Zone eine Zone ist, die durch eine physikalische, chemische oder physikalisch-chemische Veränderung geschwächt ist, der ein Bestandteil dieser Zone der Struktur unterzogen wurde.

8. Verfahren nach einem der Ansprüche 1 bis 7, **dadurch gekennzeichnet, dass** die fragile Zone eine Auftragstrennfläche ist.

9. Verfahren nach einem der Ansprüche 1 bis 8, **dadurch gekennzeichnet, dass** die fragile Zone eine poröse Zone ist.

10. Verfahren nach einem der Ansprüche 1 bis 9, **dadurch gekennzeichnet, dass** die fragile Zone eine Zone ist, die durch Implantation von gasförmigen Spezies erhalten wird.

11. Verfahren nach einem der Ansprüche 1 bis 10, **dadurch gekennzeichnet, dass** eine der beiden Unterstrukturen (613; 713) eine senkrecht zur Anlegungsebene gemessene Dicke von weniger als 50 µm besitzt.

12. Verfahren nach einem der Ansprüche 1 bis 11, **dadurch gekennzeichnet, dass** der Angriffsrand der Klinge linear, gekrümmt oder winkelig ist.

13. Verfahren nach einem der Ansprüche 1 bis 12, **dadurch gekennzeichnet, dass** der Angriffsrand unkontinuierlich ist.

14. Verfahren nach einem der Ansprüche 1 bis 13, **dadurch gekennzeichnet, dass** die Klinge sich in ihrer Ebene parallel zur Vorschubrichtung erstreckt, so dass sie zwischen die beiden Unterstrukturen während des ganzen Trennverfahrens eingesetzt bleibt.

15. Verfahren nach einem der Ansprüche 1 bis 14, **dadurch gekennzeichnet, dass** eine Saugplatine den Halt der Struktur in ihrer Stellung durch Anlegen einer Ansaugung an eine freie Fläche dieser Struktur gewährleistet.

16. Verfahren nach einem der Ansprüche 1 bis 15, **dadurch gekennzeichnet, dass** die Neigungsbewegung der Klinge durch ein Signal gesteuert bzw. geregelt wird, das von einer Kamera, beispielsweise einer Infrarotkamera kommt, die die Struktur filmt.

17. Verfahren nach einem der Ansprüche 1 bis 16, **dadurch gekennzeichnet, dass** eine der Unterstrukturen in einer zur Trennebene parallelen Richtung vom Rand aus auf das Innere der Struktur zu eine Zone maximaler Dicke (714) aufweist, dann eine Zone minimaler Dicke, die signifikant kleiner als die Dicke der Zone maximaler Dicke (713) ist, wobei die Dicke senkrecht zur Trennebene gemessen wird.

18. Vorrichtung zum Trennen einer Struktur, umfassend eine fragile Zone, die im Inneren dieser Struktur zwei Unterstrukturen abgrenzt,
wobei die Vorrichtung eine ebene Klinge (1010; 2010) und Mittel (1001, 1002, 1003, 1004; 1001', 1002'; 2001, 2003) umfasst, um die ebene Klinge in einer Vorschubrichtung (A) in einer der Mittelebene der fragilen Zone entsprechenden Trennebene von einem Eintrittsrand der Struktur aus in Richtung eines Austrittsrands der Struktur sich so vorbewegen zu lassen, dass eine allmähliche Trennung der beiden Unterstrukturen bewirkt wird,
wobei die Vorrichtung **dadurch gekennzeichnet ist, dass** sie Mittel (1003, 1004, 1015, 1016, 1017, 1018; 2004, 2020; 1001', 1002') umfasst, um die Neigung der Klinge in der Trennebene gegenüber der Vorschubrichtung sich ändern zu lassen.

19. Vorrichtung nach Anspruch 18, **dadurch gekennzeichnet, dass** die Mittel zum Ändern der Neigung der Klinge in der Trennebene gegenüber der Vorschubrichtung es gestatten, diese Neigung in einem Sinn und in dem entgegengesetzten Sinn sich ändern zu lassen.

20. Vorrichtung nach Anspruch 18 oder Anspruch 19, **dadurch gekennzeichnet, dass** die Mittel zum Vorbewegen der ebenen Klinge in einer Vorschubrichtung eine Führungsschiene (1001, 1002; 2001) umfasst.

21. Vorrichtung nach Anspruch 20, **dadurch gekennzeichnet, dass** die Klinge einen Angriffsrand zwischen zwei Enden, eine längliche Aussparung (1015, 1016) umfasst, die sich quer zur Vorschubrichtung erstreckt und in Nähe jedes Endes gelegen ist, wobei die Klinge mit zwei zueinander parallelen linearen Schienen (1001, 1002) über Stangen (1017, 1018) verbunden ist, die in die länglichen Aussparungen eingeführt sind.

22. Vorrichtung nach einem der Ansprüche 18 bis 21, **dadurch gekennzeichnet, dass** die Klinge mit Schienen über Arme mit veränderlichen Längen (1001', 1002') verbunden ist.

23. Vorrichtung nach einem der Ansprüche 18 bis 22, **dadurch gekennzeichnet, dass** die Klinge eine Dicke von höchstens gleich 100µm besitzt,

24. Vorrichtung nach einem der Ansprüche 18 bis 23, **dadurch gekennzeichnet, dass** ein Angriffsrand (1013; 2013) der Klinge abgeschrägt ist.

25. Vorrichtung nach einem der Ansprüche 18 bis 24, **dadurch gekennzeichnet, dass** sie außerdem eine Saugplatine (1020; 1021) umfasst, die es gestattet, die Struktur durch Ansaugung zu halten.

26. Vorrichtung nach Anspruch 25, **dadurch gekennzeichnet, dass** sie außerdem eine Kamera (1030; 1031), beispielsweise eine Infrarotkamera, zum Betrachten der Struktur umfasst.

27. Vorrichtung nach Anspruch 26, **dadurch gekennzeichnet, dass** die Vorrichtung außerdem Mittel (1040) zum Steuern bzw. Regeln der Bewegung der Klinge durch ein von der Kamera kommendes Signal umfasst.
